(19) Europäisches Patentamt

European Patent Office

Office européen des brevets

(11) EP 0 273 026 B2

(12) NEW EUROPEAN PATENT SPECIFICATION

(45) Date of publication and mention
of the opposition decision:
20.08.2003 Bulletin 2003/34

(45) Mention of the grant of the patent:
11.09.1996 Bulletin 1996/37

(21) Application number: 87870199.4

(22) Date of filing: 22.12.1987

(51) Int Cl.7: G03F 7/004, G03F 7/022

(54) **Solvents for Photoresist compositions**

Lösungsmittel für Photolack-Zusammensetzungen

Solvants pour compositions de photoréserve

(84) Designated Contracting States:
DE ES FR GB IT NL

(30) Priority: 23.12.1986 US 2364
13.10.1987 US 108192

(43) Date of publication of application:
29.06.1988 Bulletin 1988/26

(60) Divisional application:
96102977.4 / 0 718 693

(73) Proprietor: SHIPLEY COMPANY INC.
Newton, Massachusetts 02162 (US)

(72) Inventors:
• Daniels, Brian Kenneth
Chesterfield Missouri 63017 (US)
• Madoux, David Charles
Maryland Heights Missouri 63043 (US)
• Templeton, Michael Karpovich
St.Louis Missouri 63074 (US)
• Trefonas III, Peter
St. Louis Missouri 63146 (US)
• Woodbrey, James Calvin
Chesterfield Missouri 63017 (US)
• Zampini, Anthony
St. Louis Missouri 63146 (US)

(74) Representative:
Bunke, Holger, Dr.rer.nat. Dipl.-Chem. et al
Prinz & Partner GbR
Manzingerweg 7
81241 München (DE)

(56) References cited:
EP-A- 0 176 871          EP-A- 0 211 667
EP-A- 0 227 487          EP-A- 0 239 423
DE-A- 2 818 451          GB-A- 2 023 858
JP-A- 2 729 284          US-A- 3 635 709
US-A- 4 626 492          US-A- 5 128 230

• "LSI Process Engineering", Ohm Sha. 25.10.82
and English translation thereof
• Solid State Technology, vol. 25, no. 9, September
1982, pages 82-86

**Description**

This invention relates to photoresist compositions comprising an alkali-soluble resin, a photoactive compound and a solvent. Particularly, this invention relates to improved solvents as components of photoresist compositions having advantages including high resolution capability.

It is well known in the art to produce positive photoresist formulations such as those described in U.S. Patents 3,666,473 and 4,409,314 and European Patent Application 0092444. These include alkali-soluble phenolic-formalde-hyde novolac resins together with light-sensitive materials. Examples of the light sensitive materials are diazoquinones (DAQs) such as the sulfonate and carboxylate esters and the sulfon- and carbonamides obtained by reacting, respectively, oxo-diazonaphthalene sulfonyl and carbonyl halides with hydroxy, polyhydroxy, amino and polyamino ballast compounds (See U.S.Patent Application 174,556 filed on July 18, 1950 by Maximillian Paul Schmidt and now abandoned, and U.S. Patents 3,046,110, 3,046,122 and 3,046,123). The resins and sensitizers are dissolved in an organic casting solvent or mixture of casting solvents and are applied as a dried thin film or coating to a substrate suitable for the particular application desired.

The resin component of these photoresist formulations is soluble in aqueous alkaline solutions, but the admixed naphthoquinone sensitizer acts as a dissolution inhibitor with respect to the resin. Upon exposure of selected areas of a coated substrate to actinic radiation, the sensitizer undergoes a radiation induced chemical transformation, and the exposed areas of the coating are rendered more soluble than the unexposed area. This difference in solubility rates causes the exposed areas of the photoresist coating to be dissolved when the substrate is immersed in alkaline developing solution, while the unexposed areas are largely unaffected. This produces a positive relief resist pattern on the substrate. In most instances, the imagewise-exposed and developed resist pattern resulting on the substrate will be subjected to treatment by a substrate-etchant process. The photoresist pattern on the substrate protects the resist coated areas of the substrate from the etchant, and thus the etchant is only able to etch the remaining uncoated areas of the substrate which, in the case of a positive photoresist, correspond to the areas previously exposed to actinic radiation. Thus, an etched pattern can be created on the substrate which corresponds to the pattern of the mask, stencil, template, etc., that was used to create the latent images in the resist prior to development. The relief pattern of photoresist on the substrate produced by the method just described is useful for various applications, including the manufacture of miniaturized integrated electronic circuit components.

The term PAC as used in this present invention refers to the photoactive component of the resist composition. The PAC generally is sensitive to energetic forms of radiation such as ultraviolet (UV) light, undergoing radiation-induced chemcial transformations upon exposure to such radiation.

The properties of a photoresist composition which are important in commercial practice include the photospeed of the resist, development contrast and resist resolution capability and resist sidewall angle or wall profile, and resist adhesion. Increased photospeed is important for a photoresist, particularly in applications where light of reduced intensity is employed such as in projection exposure techniques where the light is passed through a series of lenses and monochromatic filters. Development contrast is a measure of the photoresist's ability to faithfully transfer the mask dimensions through the entire thickness of the photoresist. Ideally the opening at the top of the photoresist film should have the same dimensions as at the bottom of the film. A resist with enhanced contrast generally has improved edge acuity and enhanced resolution capability.

Resist resolution refers to the capability of a resist system to reproduce with a given phototool the smallest multiple equal line/space features of a mask which is utilized during exposure with a high degree of image edge acuity in the developed spaces. In many industrial applications, particularly in the manufacture of miniaturized electronic components, a photoresist is required to provide a high degree of resolution for very narrow lines and spaces. The ability of a resist to reproduce very small dimensions, on the order of a micron or less, is extremely important in the production of very large scale integrated (VLSI) electronic circuits on silicon chips. Circuit density on such a chip can only be increased, assuming lithographic techniques are utilized, by increasing the resolution capabilities of the resist.

The art of conventional positive photoresists is well known. For example, U.S. Patents 4,550,069 and 4,529,682 describe the principles of positive photoresist compositions, including differential solubility, contrast, photospeed, resolution, unexposed film thickness loss and applications. These and other patents describe typical embodiments, including particular plasticising resins, dyes, anti-striation agents, adhesion promoters, and speed promoters.

With respect to the solvent component, an acceptable solvent must be capable of dissolving the required amounts of photosensitizer or PAC. Typically a photoresist formulation must contain between 2.5 and 5 percent by weight PAC in order to render the dried unexposed photoresist film sufficiently insoluble in an aqueous alkaline developing solution. A widely used casting solvent composition for positive photoresists consists of a mixture of ethylene glycol monoethyl ether acetate, n-butyl acetate, and xylene in the ratio of 80:10:10, as taught in U.S. Patent 4,550,069.

The difficulty in dissolving PACs having multiple diazoquinone moieties with traditional solvents is a well known aspect of the prior art, as shown in European Patent 0,126,266 A2. Accordingly, in view of solubility limitations, it is common prior-art practice to use a mixture of sensitizers consisting of less soluble and more soluble types, or even to operate with the solution supersaturated relative to the less soluble sensitizer component. This practice can lead to precipitation of the sensitizer prior to or during use of the photoresist composition, and consequently can result in a short shelf life. There are several approaches to overcoming the solubility limitations. Among them are: (1) using a more soluble photosensitizer, (2) using a more effective solvent, and (3) using filtration of the composition immediately at the point of use. U.S. Patent 4,266,001 discloses certain organic esters of diazonaphthoquinone sulfonyl chloride (i.e. oxo-diazonaphthalene sulfonyl chloride) that are distinguished as having a high solubility in traditional photoresist solvents. Some of the prior-art photosensitizers consisting of certain esters of 1-oxo-2-diazonaphthalene-5-sulfonic acid are among the more soluble of PACs in traditional solvents, while many variations of these PACs, such as certain esters of 1-oxo-2-diazonaphthalene-4-sulfonic acid are known to be less soluble, as discussed in B. Z. Yakovlev et al., Khim. Prom-st., 9, 564, 1981.

Traditional solvents used in the prior art include: ethyl cellosolve or ethylene glycol monoethyl ether, ethyl cellosolve acetate or ethylene glycol monoethyl ether acetate, methyl cellosolve or ethylene glycol monomethyl ether, methyl cellosolve acetate or ethylene glycol monomethyl ether acetate, N,N-dimethylformamide, dioxane, and cyclohexanone, as shown in Japanese Patents 8286548 and 81202455. In order to improve coatability, up to 20 percent by weight of other solvents such as xylene, n-butyl acetate, and cyclohexane are included. Propylene glycol monoalkyl ethers are perceived by some people to be biologically safer solvents than the traditional ethylene glycol analogs (European Patent Application 85106774). Propylene glycol monoalkyl ether acetates are attributed to impart a photoresist photospeed advantage (U.S. Patent 4,550,069). Also, solvent combinations, such as solvents with 60 to 170°C boiling points admixed with solvents with 180 to 350°C boiling points, are claimed to eliminate coating striations as described in Japanese Patent Application J60024545-A.

Other solvents or mixtures of solvents have been discussed in the art as providing photoresist compositions of exceptional stability to storage. The active solvent in many of these formulations consists of pure, or in part, cyclopentanone and cyclohexanone as shown in Japanese Patent Application 84/155838. Combinations of cyclopentanone and cyclohexanone with 5- to 12-carbon aliphatic alcohols also are attributed to have good coating performance, as described in European Patent Application 0,126,266. Mixtures of acetone, ethylene glycol, and water are reported to form highly stable photoresist solutions, as shown in German Offen. DE 2319159.

Nearly all of the solvents described above, as well as others in the prior art relating to photoresist compositions containing diazonaphthoquinone-sulfonate or carboxylic acid esters of trihydroxybenzophenone, are limited in their applications. This is particularly the case when contemplated for industrial use where the combination of good solution stability, low toxicity, acceptable margin of safety against fires and explosions, and good coating characteristics is important. For example, methyl cellosolve acetate, N,N-dimethylformamide, and cyclohexanone have been implicated as biological threats to worker safety. In addition, structurally related alkylene glycol monoalkyl ethers and their acetates are potential biological threats to worker safety, as reported in the NIOSH Current Intelligence Bulletin 39, May 1983.

In order to provide an optimal margin of safety against fires and explosions, it is desirable for the photoresist composition to have as high a flash point as possible. This substantially restricts the use of highly volatile solvents such as acetone, cyclopentanone, and 1,4-dioxane, since these solvents have unacceptably low flash points. Since flash point generally correlates well with boiling point, the need for safety against fire and explosions places substantial restrictions on using solvents with boiling points below 110°C in photoresist compositions.

In addition to safety issues, the use of highly volatile solvents presents severe coating problems as well. Since efficiently practicing the art of high resolution microlithography requires maintaining critical dimension control from wafer edge to wafer edge, it is essential for a photoresist coating to have an extremely high degree of thickness uniformity, typically less than 50 angstroms variation across a 100 mm diameter substrate. Solvent mixtures containing as little as 5 percent of solvents with boiling points below 110°C tend to produce unacceptable thickness variation, because the drying time is likely to be too short compared to the spreading time in a typical spin coating process.

On the other hand, it is important for a photoresist solvent to be volatile enough to evaporate nearly completely during the coating process. This requirement places severe restrictions on the use of relatively high boiling solvents in photoresist compositions, especially since the post spin bake temperature cannot be raised much above 110°C without causing substantial thermal decomposition of the photosensitizer.

Finally, the distinction between physical solution stablility and chemical reactivity should be made. As discussed above, the literature has a number of examples of highly stable photoresists based on solvent mixtures containing cycloaliphatic ketones. Although these photoresists are highly stable in the sense that the photosensitizer does not precipitate out of solution, they are chemically unstable. The diazo moieties are reactive towards cycloaliphatic ketones. It is well known that the color of solutions of photosensitizer and cyclopentanone, for example, turns from red to black on standing at room temperature for just a few days. Opening sealed sample vials of such solutions is accompanied by audible release of pressurized nitrogen gas, indicating that the photosensitizer has undergone decomposition. The same is true of many amines, even to a higher degree. It is essential for industrially viable photoresist compositions to be free of such degradation effects. Therefore, it is an object of the present invention to provide improved solvents for photoresist compositions resulting in a combination of good solution stability, low toxicity, acceptable margin of safety against fires and explosions, and good coating characteristics.

According to the invention, there is provided a composition responsive to activating radiation to form a latent image developable with an aqueous alkali solution comprising at least one alkali soluble resin anc at least one photoactive compound that is an ester or polyester derived from the reaction of an oxodiazonaphthalene sulfonyl or carboxylic acid halide with a hydroxy or polyhydroxy ballast compound dissolved in a solvent mixture comprising anisole, ethyl lactate and amyl acetate; with the ethyl lactate preferrably being present in at least 60 percents by weight based on the total weight of said solvent mixture.

In particular, the solvent mixtures of the present invention are containing ethyl lactate having a purity of greater than 99 percent.

The photoresist compositions of the present invention may further comprise one or more additives selected from the group consisting of colorants, dyes, anti-striation agents, plasticizers. speed-enhancers, contrast-enhancers, and surfactants. The compositions are used for coating solid supports, in particular for coating semiconductor materials, metals, planarizing, barrier or etch-resistant types of organic or inorganic layers, underlying films and coatings, other types of resist films, antireflective coatings, plastic films, wood, paper, ceramics, glass, laminates, and textiles. They are especially useful for coating silicon-based or gallium-arsenide-based wafer, aluminium, and silicon dioxide. The compositions are preferably used in the manufacture of integrated electronic circuits.

Other objects, aspects and advantages of this invention will become apparent to those skilled in the an upon further study of this specification and appended claims.

The present invention relates generally to photoresist compositions with PACs which are sensitive to energetic radiation. The energetic radiation typically consists of ultraviolet light, although other forms of radiolysis, including x-rays, gamma-rays, synchrotron radiation, electron beams and particle beams also may be used.

For many purposes, the photoresist compositions of the present invention are commonly used in a positive printing mode. Techniques for using the compositions of the present invention in the negative mode are also well known to those skilled in the art, examples of which are described by E. Ailing and C. Stauffer, Proc SPIE, Vol. 539, pp 194-218 (1985) and F. Coopmans and B. Roland, Proc. SPIE. Vol. 631, pp. 34-39 (1986).

Photoresist compositions of the present invention are also useful in a multilayer printing process. For example, these compositions can be used as an imaging layer coated on top of a planarizing layer for example, as described by A.W. McCullough et al., Proc. SPIE, Vol. 631, pp 316-320 (1986). These compositions can also be useful as a planarizing layer in a multilayer process, for example, as described by S.A. McDonald et al.. Proc. SPIE, Vol. 631, pp 28-33 (1986).

The alkali-soluble resins of the present invention are preferably cresol novolac resins produced by condensing with formaldehyde a mixture of cresol isomers with the various cresol isomers present in proportions such that the cresol mixture consists essentially of less than 30 percent ortho-cresol. 25 to 46 percent meta-cresol and 24 to 75 percent para-cresol.

These resins are prepared as described in Chapter 5 of Phenolic Resins. A. Knop and L.A. Pilato., Springer-Verlag, New York, 1985. After the resin is produced. it is characterized using solution viscosity measurements, differential scanning calorimetry, gel permeation chromatography and, in some examples, by combined gel permeation chromalography - low angle laser light scattering measurements as practiced in the art. The cresol-formaldehyde novolac resins useful in the present invention all have a glass transition temperature of 100 to 105°C and weight-average molecular weight of 4,000 to 35,000 Daltons

Another useful class of phenolic resins of the present invention is based on bishydroxymethylated phenolic compounds. A bishydroxymethylated phenolic compound such as 2,6-bis(hydroxymethyl)-p-cresol may be produced by reacting para-cresol with formaldehyde in the presence of a base. The bishydroxymethyl group of the compound is reactive and may in the presence of heat, acid or base react with itself or with other reactive compounds. If the other reactive compound is a phenolic material, such as phenol, cresol, dimethylphenol, trimethylphenol, naphthol, biphenol, phenylphenol, bis(hydroxyphenyl)methane, isopropylidenebiphenol, catechol, resorcinol, thiobiphenol and the like, which contain at least two sites in the aromatic ring(s) of sufficient reactivity to undergo facile Friedel-Crafts reactions, then the condensation reaction of the said reactive compound with a bis-hydroxymethylated phenolic compound can sustain polymerization and result in the formation of polymers. If the reactants are of good purity, then high-molecular-weight polymers can be made. To prepare polymers having utility in photoresist compositions, the bishydroxymethylated phenolic compound and the reactive phenolic compound are dissolved in an appropriate non-reactive or non-interfering solvent and an acid catalyst is added. When a volatile reactive phenolic compound is used in excess, it may also serve as a solvent or co-solvent. The condensation reaction leading to polymer formation can be carried out below ambient, at ambient or above ambient temperature. It is generally more practical to conduct the reaction at elevated temperature. A suitable acid catalyst may be a mineral acid such as hydrochloric acid, sulfuric acid, phosphoric acid, or an organic acid such as oxalic acid, maleic acid, formic acid, toluenesulfonic acid and the like. In certain cases, inorganic catalysts may also be used. These may include compounds of Zn, Mn, Mg, Al, Ti, Cu, Ni and Co. Upon completion of the condensation reaction the solvent and unreacted reactive phenolic compound may be removed via volatilization under reduced pressure and elevated temperatures. Another method by which the polymer may be recovered from the reaction mixture is by precipitation of the polymer into a liquid which is a non-solvent for the polymer but a solvent for the reaction solvent, catalyst and unreacted reactants. If the precipitation approach is used, the polymer is dried at elevated temperatures under reduced pressure. The polymer produced in this manner has substantially an alternating copolymer structure.

The substantially alternating copolymer produced by the acid catalysed condensation reaction of a bishydroxymethylated phenolic compound and a reactive phenolic compound can be further reacted in the presence of acid with formaldehyde and the same or different reactive phenolic compound. The resin that results is substantially a block copolymer.

Two or more resins of similar or different compositions can be blended or combined together to give additional control of lithographic properties of photoresist compositions. For example, blends of resins can be used to adjust photospeed and thermal properties and to control dissolution behavior in developer.

Higher resolution patterning capability is required as the density of circuits in electronic devices increases; e. g., as the industry progresses from VLSI to ultra large scale integration (ULSI) of circuit devices. Economical enhanced resolution patterning capability is offered by higher resolution photolithography. This generally requires higher resolution and higher contrast resist materials, which can tolerate a greater extent of degradation of the light aerial image caused by diffraction phenomena as feature size decreases. Increased resist contrast generally is a measure of increased resolution capabilities.

Positive photoresists containing DAQ sulfonic and carboxylic acid esters as the PAC(s) in a novolac polymer matrix are high resolution materials which do not swell during development and possess good dry-etch resistance. Typically, a suitable hydroxy-functional ballast compound, molecule or group is esterified with the DAQ group to give a base-insoluble ester PAC which greatly reduces the dissolution rate of the admixed base-soluble resin in an aqueous alkaline developer. Other substituent groups can be bonded to the ballast molecule to modify the solubility properties of the PAC. Acidic hydrophilic substituent groups such as acid and hydroxyl, or other hydrophilic groups such as polyethylene oxide groups, enhance the solubility of the PAC molecule in aqueous solutions. Hydrophobic substituent groups such as hydrocarbons, aryl halide, alkyl esters and aryl halide groups diminish the solubility of the PAC molecule in aqueous solutions. Upon photolysis in the presence of water, such as upon the irradiation of thin films under normal conditions, the DAQ groups undergo a sequence of reactions to ultimately form indene carboxylic acid (ICA) groups, which make the photolyzed PAC base-soluble. Thus, the irradiated regions of the photoresist film become soluble in the alkaline developer. The photochemistries of DAQ groups linked to the ballast molecule through carboxyl ester, sulphonate ester, carbonamide or sulfonamide linkages are essentially equivalent in terms of the photochemical and subsequent reactions which cause the PAC to become base-soluble. Normal conditions are normal ambient temperature and humidity such as about 16 to 25°C (61 to 77°F) and about 25 to 75 percent relative humidity. If two or more DAQ groups are bonded to the same ballast group to form a multi-DAQ PAC, the DAQ groups undergo essentially independent sequential photolysis with increasing dose to ultimately form a multi-ICA product.

The solvents of the present invention offer several new advantages, including: (1) better photosensitivity (2) lower toxicity, (3) an equivalent cast film thickness from lower percent solids formulations than with traditional solvents, and (4) better solvency and solution stability.

The importance of photosensitivity is well documented in the literature. Materials showing higher photosensitivities allow the photolithography process to have a higher throughput in terms of wafers exposed per hour. This translates into economic advantages of lower cost devices.

Without question, toxicity is an important issue in the workplace, especially since the traditional photoresist solvent, ethylene glycol monoethyl ether acetate, and related compounds such as ethylene glycol monomethyl ether acetate, have been found to be teratogenic (NIOSH Current Intelligence Bulletin 39, May 1983).

Photoresist compositors made with some of the solvents of this invention, have the property that, for a fixed percent solids, they give thicker films than compositions based on the traditional solvents. This effect translates into an economic advantage in that less of the expensive solid materials are required to produce a given coating thickness than with compositions made with traditional solvents.

The solvency power of a solvent or solvent mixture useful in positive photoresist compositions according to this invention can be exemplified in terms of solubility parameters, 6. The development of the solubility parameter concept is related closely to developments in the theory of dissolution of organic compounds and polymers, or more specifically non-electrolytes. (See H. Burrell, "Solubility Parameter Values," in Polymer Handbook, 2nd Edn., J. Brandup and I.H. Immergut, Eds., John Wiley, 1975.) The dissolution of a material is governed by the well known free energy equation:

$$\Delta G = \Delta H - T\Delta S$$

where ΔG is the Gibb's free energy change, ΔH is the heat of mixing, T is the absolute temperature, and ΔS is the entropy of mixing. A decrease in free energy, or negative ΔG, implies that the dissolution will tend to occur spontaneously.

Since the dissolution process is always associated with a positive change in entropy, the magnitude of the ΔH is the deciding factor in determining the sign of the free energy change. Hildebrand and Scott proposed that

$$\Delta H_m = V_m\left[\left(\frac{\Delta E_1}{V_1}\right)^{\frac{1}{2}} - \left(\frac{\Delta E_2}{V_2}\right)^{\frac{1}{2}}\right]^2 \phi_1\phi_2$$

where $\Delta H_m$ is the overall heat of mixing; $V_m$ is the total volume of the mixture; $\Delta E$ is the energy of vaporization of the respective component 1 or 2; V is the molar volume of component 1 or 2; $\phi$ is the volume fraction of the designated component 1 or 2 in the mixture. (See J. Hildebrand and R. Scott, The Solubility of Non-Electrolytes, 3rd Edn., Reinhold, N.Y., 1949.) The quantity $(\Delta E/V)$ has been variously described as the "cohesive energy density," or $\delta^2$.

A number of workers, including C.M. Hansen, have extended the single component solubility parameter concept of Hildebrand by taking into account the various intermolecular attractions that give rise to $\delta^2$. (See C.M. Hansen, The Three Dimensional Solubility Parameter and Solvent Diffusion Coefficient, Danish Technical Press, Copenhagen, 1967.) These attractions are mainly due to dispersion forces, dipolar forces, and hydrogen bonds. Thus $\delta^2$ can be written as:

$$\delta^2 = \delta_d^2 + \delta_p^2 + \delta_h^2.$$

The parameters themselves are computed by a number of methods, from equations of state, boiling points, densities, critical properties, etc. For purposes of this invention, it is appropriate to employ parameters determined after K.L. Hoy. (See K.L. Hoy, Tables of Solubility Parameters, Union Carbide Corporation Solvents and Coatings Materials Research and Development Department, Bound Brook, N.J., 1985.) The aggregate solubility parameter for a mixture, often referred to as simply the solubility parameter of the mixture, is the volume-fraction weighted-average of that solubility parameter for the components of the mixture.

In practice, these parameters are typically utilized in the form of a two dimensional plot of, for example, $\delta_p$ versus $\delta_h$. This surface contains a locus of points which define a characteristic region of solubility for a specific organic compound or polymer. Furthermore, any solvent or solvent mixture with solubility parameters $\delta_p$ and $\delta_h$ that fall within this region, will solubilize that particular organic compound or polymer. (See, for example, A.F.M. Barton, CRC Handbook of Solubility Parameters and Other Cohesion Parameters, CRC Press, Boca Raton, Florida 1983.)

Typically the locus of points is empirically mapped out by conducting solubility tests of an organic compound with various solvents or solvent mixtures having known solubility parameters.

We have empirically determined a locus of points in solubility-parameter space corresponding to regions of solubility of various multi-DAQ PACs and mixed mono-, di-, and fit-DAQ PACs. These PACs have oxo-diazonaphthalene photoactive substituents bonded to various functional ballast groups through intervening linkages. The solvents and solvent mixtures utilized have broad ranges of solubility parameters or aggregate solubility parameters $\delta_d$, $\delta_p$ and $\delta_h$. For PACs based on similar types, relative amounts and dispositions of functional ballast groups and oxo-diazonaphthalene substituent groups, the solubilities of the PACs with carbonyl- and sulfonate ester and carbon- and sulfonamide intervening linkages are substantially the same. Instead of a cylindrical region of solubility-parameter space, as is typical of polymers, we have found that the region of solubility for the PACs corresponds more closely to the volume of solubility space defined by:

$$\delta_d > 4.4,$$

$$\delta_p > 3.6,$$

$$\delta_h > 3.0$$

and

$$\delta_p/\delta_h > 0.59,$$

where $\delta_d$, $\delta_p$, and $\delta_h$ are in units of $(cal/cm^3)^{0.5}$.

A solvent or mixture of solvents with solubility parameters in the above indicated region would not be wholly adequate as a practical photoresist solvent if it also possessed one or more of the following detrimental characteristics: 1) toxicity, 2) low margin of safety due to too low flash point, 3) poor coating characteristics. 4) insufficient volatility and dryability; and 5) reactivity towards PACs.

Therefore, in view of these factors, acceptable materials should:

   i. have boiling point between 110°C and 180°C.
   ii. consist of C, H and one or more of the elements: Cl, F, O.
   iii. exclude cycloaliphatic ketones,
   iv. exclude alkylene glycol monoalkyl ether acetates and related derivatives such as ethylene glycol monomethyl ether acetate.

Because the biological activity of solvents within the region of this invention generally increases with increasing solubility parameters, the solvents of this last class generally offer the combination of high solvency and lower biological activity.

From group constants, the dispersive, polar, and hydrogen bonding components of the solubility parameter of alkali-soluble phenolic resins are estimated to be 8.6, 5.7, and 3.7, respectively. (See K.L. Hoy, Tables of Solubility Parameters, Union Carbide Corporation Solvents and Coatings Materials Research and Development Department, Bound Brook, N.J., 1985.) Since these solubility parameters are within the preferred region of PAC solvency, combinations of solvents with such resins, as in liquid photoresist compositions, generally will only change the overall solubility parameters towards improved solvency and solution stability.

The following specific examples provide detailed illustrations of the methods of producing and using the compositions of the present invention. These examples are not intended, however, to limit or restrict the scope of the invention in any way, and should not be construed as providing conditions, parameters or values which must be utilized exclusively in order to practice the present invention.

EXAMPLE 1

Novolac Resin from m- p- and o-Cresols

A 2-L four-neck resin kettle equipped with a stirrer, heating source, thermometer, variable reflux ratio distilling head and a nitrogen inlet tube was charged with 278.3g (99 percent pure) m-cresol, 335.5g (99 percent pure) p-cresol, 34.3g (99 percent pure) o-cresol, 66.3g of 36.9 percent formalin, 20 ml of deionized water and 12.0g of oxalic acid dihydrate. The mixture was heated to about 60°C at which point an exothermic condensation reaction ensued. When the reaction mixture temperature reached about 100°C, 273.3g of 36.9 percent formalin was added in about 30 minutes. The reaction was then allowed to continue for about 4 hours at reflux temperature. The more volatile components in the reaction mixture were removed by distillation at ambient pressure under a constant flow of nitrogen. When the temperature of the reaction mixture reached about 220°C, a partial vacuum pressure was applied and was gradually increased until a maximum vacuum of 7 mm Hg was achieved and the mixture was at about 228°C. The liquefied resin remaining in the kettle was poured into a tray under nitrogen and allowed to cool and solidify About 516g of novolac resin having a glass transition temperature, Tg, of about 100°C was obtained.

EXAMPLE 2

Novolac Resin from m-Cresol and 2,6-Bis(hydroxymethyl)-p-cresol

A phenolic resin rich in alternating phenolic copolymer block segments was formed by reacting a mixture of 519.0g of 99 percent pure m-cresol, 538.2g 97 percent pure 2,6-bis(hydroxymethyl)-p-cresol and 20g oxalic acid dihydrate in a solvent mixture of 40 ml deionized water and 200 ml ethyl cellosolve acetate. The reaction mixture was heated to about 70°C to initiate the reaction forming the copolymer block segments. At 102°C, 32.6g of 36.9 percent formaldehyde was added in 8 minutes to the reaction mixture to form substantially m-cresol formaldehyde block segments and to chemically bond these segments to the previously formed copolymer blocks. After heating the mixture at reflux for three hours, the amount of heat was increased to remove the water and solvent by distillation. Partial vacuum was applied at about 220°C and gradually increased to 4 mm Hg to remove the unreacted monomers. Maximum mixture temperature during vacuum stripping was about 226°C. The copolymer was poured from the reaction kettle and allowed to cool. About 840g of product having a Tg of 112°C was obtained.

EXAMPLE 3

A m-Cresol-Salicylaldehyde Resin

A mixture of 183.2g salicylaldehyde, 162.2g m-cresol, 5.0g 3-mercaptopropionic acid, 1.5g of a 50 percent aqueous solution of p-toluenesulfonic acid and 200 ml glacial acetic acid were charged into a 1-L reaction vessel equipped with a paddle stirrer, reflux condenser and a nitrogen inlet tube. The mixture was heated to reflux and maintained at reflux for 16 hours. The reaction mixture was slowly poured into 7 L deionized water to precipitate the resin. Once the solvent had exchanged with water, the product was collected on a filter, slurried once in warm deionized water for about 30 minutes, again collected, rinsed with water and dried in a vacuum oven under about 125 mm Hg and at about 100 to 105°C. About 286g of a brown powder suitable as a binder in resist compositions was obtained.
Photoresist compositions were prepared as described in Examples 25 and 26. These compositions were evaluated according to the procedure described in Example 10.

EXAMPLE 4

Alpha,alpha'-bis-(2,3,4-trihydroxyphenyl)-1,4-diisopropylbenzene was prepared by the following two methods:

A. 101.5g pyrogallol, 19.2g alpha,alpha'-dihydroxy-p-diisopropylbenzene and 150 ml ethanol were placed in a 500-ml flask. Upon dissolution of the solids, 2.0g p-toluenesulfonic acid monohydrate was added, the mixture was warmed to about 59°C to 69°C and kept at this temperature for about 21 hours. The reaction mixture was slowly added to 2 L of deionized water, the precipitate was collected on a filter and slurried twice in 1.8 L of water. The precipitate was vacuum dried at 60°C to yield about 33.5g of a product mixture containing at least 90 percent of alpha, alpha'-bis-(2,3,4-trihydroxyphenyl)-1,4-diisopropylbenzene as determined by high pressure liquid chromatography.
B. 201.8g Pyrogallol, 31.6g p-diisopropenyl-benzene and 300 ml ethanol were added to a flask and stirred at 23°C until the pyrogallol dissolved. 4.0g of p-toluenesulfonic acid monohydrate was added, and the mixture was stirred at ambient temperature for 24 hours. The product was precipitated in 4 L deionized water, washed with copious amounts of water, and vacuum dried at 60°C. About 73.5g of a product mixture was obtained containing at least 90 percent of alpha,alpha'-bis-(2,3,4-trihydroxyphenyl)-14-diisopropylbenzene. Similar results were obtained when HCl was used as a catalyst.

The PACs prepared in accordance with Examples 5 to 8 were all characterized by analytical procedures accepted in the art. High pressure liquid chromatography was particularly useful to determine the product mixtures in the polyesters.

EXAMPLE 5

An Oxo-diazonaphthalene-sulfonate Mixed Ester of 2,3,4-Trihydroxybenzophenone:

To a 25-L flask equipped with a constant temperature bath, thermometer, mechanical stirrer, and 2 1-L addition funnels were added 550g (2.50 moles) of 2,3,4-trihydroxybenzophenone, 750g (2.80 moles) of 1-oxo-2-diazonaphthalene-5-sulfonyl chloride and 11.350 L of reagent grade acetone. While the mixture was maintained at 20°C ± 0.3°C, 1425g (1.61 moles) of 12 percent sodium carbonate was added dropwise over 100 minutes. After the base addition, the reaction mixture was allowed to stir for 60 minutes at about 20°C. 250 ml of concentrated HCl was then slowly added to the mixture while keeping its temperature below 26°C. The reaction solution was filtered to remove the bulk of the NaCl, and the filtrate was added to 50 L of 1 percent HC1. The precipitated solid was stirred one hour, filtered and collected. The solid was slurried twice in 25 L of deionized water, filtered and vacuum dried to 0.1 mm Hg at ambient temperature. About 1100g (85 percent of the theory) of a yellow, free flowing product containing about 34 percent by weight triester was obtained. By changing the ratio of the 1-oxo-2-diazonaphthalene-5-sulfonyl chloride to 2,3,4-trihydroxybenzophenone, the percent by weight of triester in the PAC product, and thus the percent by weight of PAC molecules without acidic hydrophilic groups, can be adjusted as desired.

Examples 6 and 7 demonstrate the utility of preparing acetylated photoactive polyester compounds containing either low or high levels of the acetyl group. Intermediate levels of acetylation can be achieved by adjusting the amount of the acetylation reactant added to the reaction mixture. This method is useful for controlling the percent by weight of the PAC molecules without acidic hydrophilic groups.

EXAMPLE 6

Preparation of a 50 Percent Acetylated Mixed Oxo-diazonaphthalene-sulfonate Ester of 2,3,4-Trihydroxybenzophenone

To a 5-L round bottom flask equipped with a mechanical stirrer, thermometer, and a 50-ml addition funnel was added: (1) 50g of a mixed 1-oxo-2-diazo-naphthalene-5-sulfonate ester of 2,3,4-trihydroxybenzophenone containing approximately 0.19 equivalents per mole of unreacted hydroxy groups, (2) 0.1g of dimethylaminopyridine, and (3) 10g (0.098 moles) of acetic anhydride. After dissolving the mixture in 3000 ml of reagent grade acetone at ambient temperature, 300 ml of deionized water was added, followed by the dropwise addition of 9.8g (0.098 moles) of triethylamine. The reaction temperature was kept at 45°C during the addition. The mixture was allowed to stir for one hour and then slowly poured into 8 L of 2 percent HCl. The precipitated solid was stirred for one hour and then filtered. The filter cake was broken up and slurried twice in 2 L of deionized water. The product was dried under 125 mm Hg pressure at ambient temperature. The yield, 49g, was approximately 80 percent of theory. Greater than 80 percent by weight of the product molecules were free of acidic hydrophilic groups.

EXAMPLE 7

Preparation of a Fully Acetylated Mixed Oxo-diazonaphthalene-sulfonate Ester of 2,3,4-Trihydroxybenzophenone

To a 2-L round bottom flask equipped with an ice bath, mechanical stirrer, thermometer, and a 50-ml addition funnel 40g of a mixed 1-oxo-2-diazo-naphthalene-5-sulfonate ester of 2,3,4-trihydroxybenzophenone (having approximately 39 percent triester and 0.152 equivalents per mole free hydroxyl), was dissolved in 150g (1.47 moles, 9 fold excess) acetic anhydride at ambient temperature. After the dissolution was completed, 100 ml of 50 percent sodium hydroxide was added dropwise at such a rate as to keep the temperature below 55°C. The mixture was allowed to stir for one hour after the addition to insure complete reaction of the anhydride. The resulting mixture was slowly added to 3 L of 2 percent HCl. The precipitate was stirred one hour in the HCl solution and then filtered. The filter cake was broken up and slurried twice in 2 L of deionized water. The product was dried at ambient temperature and at a pressure of about 125 mm Hg. About 35g (75 percent of theory) of product was recovered, and found to be essentially free of molecules with acidic hydrophilic groups.

EXAMPLE 8

Oxo-diazonaphthalene-sulfonate Esters of Alpha,alpha'-bis(2,3,4-trihydroxyphenyl)-1,4-diisopropylbenzens

In a 5-L 3-neck round bottom flask equipped with a thermometer, mechanical stirrer, and a 1-L addition funnel, 69.5g (0.17 moles) of alpha, alpha'-bis(2,3,4-trihydroxyphenyl)-1,4-diisopropylbenzene and 314g (1.17 moles, 15 percent excess) of 1-oxo-2-diazo-naphthalene-5-sulfonyl chloride were dissolved in 3 L of acetone at ambient temperature. After the dissolution was completed, 300 ml of deionized water was slowly added, followed by 5g of dimethylaminopyridine. To the resulting mixture, 118g (1.17 moles) of triethylamine was added dropwise with stirring at such a rate as to keep the temperature at or below 35°C. Following the addition, the mixture was stirred for one hour, and then filtered through a course filter to remove insolubles. The product was precipitated by slowly adding to 6 L of 2 percent HCl. The precipitate was stirred one hour in the precipitation media and then filtered. The solid was broken up and slurried twice in 2 L of deionized water, twice in 4 L of methanol, filtered and vacuum dried at ambient temperature at a pressure of about 125 mm Hg. About 184g (60 percent of theory) of a yellow solid was obtained and found to be essentially free of molecules with acidic hydrophilic groups.

EXAMPLE 9

Solubility of PACs in Pure Solvents

The following examples consist of mixtures of 5.4 percent PAC, selected from a group of 4 different PACs, and 94.6 percent of a pure solvent selected from a group of 37 different solvents with widely ranging solubility parameters. These mixtures were formulated at room temperature and mixed thoroughly. The resultant mixtures were then inspected to see whether or not the PAC dissolved completely. Table I lists the 37 pure solvents in Column A along with their corresponding solubility parameters in columns B, C, D, and E, which respectively contain the dispersive, polar, hydrogen bonding, and total contributions. Columns G, H, I and J report the resuits concerning the solubility of the PAC's in the pure solvents. For example, a "1" in column G indicates that the substantially pure 1-oxo-2-diazonaphthalenesulfonate triester of 2,3,4-trihydroxybenzophenone, "triester," prepared according to a method such as that described in Example 5, is completely soluble in pure solvent, while a "0" in column G indicates that the triester is not soluble. Columns H, I and J, respectively, report results for examples using the hexa-DAQ PAC, "hexaester," of Example 8 and two different mixed-DAQ PACs, "mixed esters-1 and -2," containing 1 to 3 1-oxo-2-diazo-naphthalene-5-sulfonate groups per ballast molecule.

Table I shows that solvents with solubility parameters described herein will solubilize at least one, and usually more than one, of the four types of PACs listed. The converse is also true, with only a few exceptions. Thus, these examples demonstrate the high intrinsic solubility, and therefore high stability of the corresponding photoresists, of PACs in the solvents with solubility parameters within the region described herein.

TABLE 1:
PAC Solubility versus Solvent

| Solvent | dispersive | polar | hydrogen | total | Triester Result | Hexaester Result | Mixed Ester-1 Result | Mixed Ester-2 Result |
|---|---|---|---|---|---|---|---|---|
| butrolactone,gamma- | 9.11 | 5.98 | 6.83 | 12.87 | 1 | 1 | 1 | 1 |
| dimethyl formamide | 8.53 | 6.72 | 5.54 | 12.16 | 1 | 1 | 1 | 1 |
| ethyl lactate | 5.77 | 5.37 | 6.93 | 10.50 | 0 | 1 | 1 | 1 |
| cyclopentanone | 7.94 | 5.42 | 4.29 | 10.53 | 1 | 1 | 1 | 1 |
| cyclohexanone | 7.64 | 4.58 | 5.39 | 10.42 | 1 | 1 | 1 | |
| methyl benzoate | 7.76 | 5.60 | 3.51 | 10.19 | 1 | 1 | 1 | 1 |
| 1,4 dioxane | 7.96 | 4.94 | 3.84 | 10.13 | 0 | 1 | 1 | 1 |
| methylene chloride | 6.55 | 5.71 | 4.70 | 9.88 | 0 | 1 | 1 | 0 |
| acetone | 6.37 | 4.79 | 5.39 | 9.62 | 1 | 0 | 1 | 1 |
| Diacetone alcohol | 5.21 | 5.56 | 6.14 | 9.78 | | | 1 | 1 |
| anisole | 7.68 | 5.04 | 3.26 | 9.74 | 0 | 0 | 1 | 1 |
| 1egmmea | 7.02 | 4.41 | 4.33 | 9.35 | 0 | | 1 | 1 |
| 2pgmmea | 6.91 | 4.51 | 3.82 | 9.09 | 0 | 0 | 1 | 1 |
| tetrahydrofuran | 6.52 | 5.36 | 3.25 | 9.05 | 0 | | 1 | 1 |
| ethyl-3-ethoxy-propionate | 6.98 | 4.13 | 3.89 | 8.99 | 0 | 0 | 1 | 0 |
| 2-heptanone | 7.38 | 3.73 | 3.52 | 8.98 | 0 | 0 | 0 | 1 |
| ethyl acetate | 6.55 | 4.20 | 4.35 | 8.91 | 0 | 0 | 1 | 0 |
| ethylene glycol | 4.93 | 7.37 | 14.56 | 17.05 | 0 | 0 | 1 | 0 |
| 2-propanol | 6.86 | 4.79 | 7.81 | 11.45 | | 0 | | 0 |
| n-pentanol | 7.25 | 4.44 | 7.17 | 11.12 | 0 | | 0 | |
| n-hexanol | 7.34 | 4.17 | 6.68 | 10.77 | 0 | | 0 | |
| chlorobenzene | 8.49 | 4.59 | 0.00 | 9.65 | 0 | 0 | 0 | 0 |
| xylene | 8.07 | 3.44 | 0.97 | 8.83 | 0 | 0 | 0 | 0 |
| diethyl carbonate | 8.14 | 1.52 | 2.99 | 8.77 | 0 | | 0 | |
| n-butyl acetate | 7.09 | 3.79 | 3.30 | 8.69 | 0 | 0 | 0 | 0 |
| amyl acetate,n | 7.01 | 3.56 | 2.78 | 8.34 | 0 | 0 | 0 | 0 |
| acetol | 4.50 | 6.46 | 9.49 | 12.33 | 0 | 1 | 0 | 1 |
| butyl butyrate | 7.15 | 3.37 | 3.02 | 8.46 | 0 | 0 | 0 | 0 |
| Ethyl 2-ethoxy-2-hydroxyacetate | 5.06 | 4.40 | 5.34 | 8.57 | 1 | 1 | 1 | 1 |
| Ethyl 2-hydroxylsobutyrate | 5.01 | 5.01 | 5.22 | 8.80 | 0 | 0 | 1 | 1 |
| Ethyl acetoacetate | 6.51 | 5.42 | 4.98 | 9.83 | 1 | 0 | 1 | 1 |
| Ethyl pyruvate | 5.78 | 5.83 | 5.23 | 9.73 | 1 | 0 | 1 | 1 |
| Hexyl acetate | 7.30 | 3.40 | 3.13 | 8.64 | 0 | 0 | 0 | 0 |
| Malonaldehyde tetramethyl acetal | 6.26 | 4.21 | 3.96 | 8.52 | 0 | 0 | 0 | 0 |
| Methyl acetoacetate | 6.65 | 5.94 | 5.84 | 10.66 | 1 | 1 | 1 | 1 |
| Methyl isobutyl ketone | 6.90 | 3.92 | 3.02 | 8.49 | 0 | 0 | 1 | 0 |
| Pyruvic aldehyde dimethyl acetal | 6.81 | 4.27 | 4.58 | 9.25 | 1 | 0 | 1 | 1 |

1egmmea is ethylene glycol monoethyl ether acetate
2pgmmea is propylene glycol monomethyl ether acetate

EXAMPLES 10 through 16 (Examples 10 - 15 are for comparison purposes, only Example 16 is an embodiment of the present invention)

Measurement of Resist Contrast and Photospeed

A series of lithographic experiments were conducted in order to determine the dependence of resist contrast and resolution on the number of DAQ groups bonded to the same ballast group. Resist compositions containing the high resolution novolac resin of Example 1, and the PAC, a 1-oxo-2-diazo-naphthalene-5-sulfonate polyester of trihydroxybenzophenone of Example 5, are evaluated in a variety of developer concentrations. The tri-DAQ content of the PAC in these compositions was varied between 34.5 to 96.5 weight percent, with the remainder consisting of mono-DAQ esters, di-DAC esters and free trihydroxybenzophenone. 10

Five photoresist compositions (Examples 10 to 14 in Table II) were prepared according to the following formula: 2.831 g of PAC and 12.47g of novolac resin were dissolved into 4.064g of anisole and 40.636g of propylene glycol monomethyl ether actetate. These compositions were then filtered through a 0.2 μm Teflon filter into a clean bottle.

In order to determine the lithographic effect of varying the solvent composition and the effect of varying the PAC concentration, two additional compositions (Examples 15 and 16 in Table II) were prepared according to the following formula: Example 15; 2.007g of PAC and 10.693g of novolac resin was dissolved into 3.391g of anisole and 33.91 g of propylene glycol monomethyl ether actetate. This composition was then filtered through a 0.2 μm Teflon filter into a clean bottle. Example 16: 2.007g of PAC and 10.693g of novolac resin was dissolved into 5.036g of anisole, 5.036g of amyl acetate and 27.23g of ethyl lactate. This composition was then filtered through a 0.2 μm Teflon filter into a clean bottle.

The thusly prepared photoresists were evaluated as follows: 23 4-inch silicon wafers were spin-coated with resists of Examples 10 to 16 on a SVG coater-hotplate track to give a 1.2 μm film of photoresist and baked at 100°C for 45 seconds. Initial average film thickness was measured with a Nanometrics Nanospec. The films were irradiated with UV light dosages of 30 to 300 mJ/cm$^2$ through a Ditric gradient density step tablet mask to give varying exposures on the photoresist surfaces. The compositions were developed in TMAH/water developer of concentrations between 0.213 and 0.299 molar at 22°C. The developed film thicknesses were measured and the normalized film thicknesses plotted against the loganthm of the exposure dose in order to generate a contrast curve. A straight line plot was obtained by extrapolation.

The resuits are tabulated in Table II. It is readily observed that resist compositions containing a PAC with a high tri-DAQ content can have excellent contrast. Resist contrast can be improved by using developer solutions of certain normalities. Comparison of compositions 15 and 16 show that high contrast can be obtained in both solvents, and that solvent composition can also affect resist performance.

Table II

| Examples 10 through 16 | | | | |
|---|---|---|---|---|
| Photospeed and Contrast | | | | |
| Example | Percent Tri-DAQ Content | †Developer Concentration | Photospeed mJ/cm$^2$ | Contrast |
| 10 | 96.5 | 0.213 | 66.9 | 3.06 |
| 10 | 96.5 | 0.233 | 56.0 | 3.33 |
| 10 | 96.5 | 0.245 | 51.6 | 3.13 |
| 10 | 96.5 | 0.273 | 38.4 | 3.29 |
| 10 | 96.5 | 0.299 | 30.4 | 3.12 |
| 11 | 80.0 | 0.213 | 53.5 | 3.08 |
| 11 | 80.0 | 0.233 | 49.7 | 2.55 |
| 11 | 80.0 | 0.245 | 42.5 | 2.76 |
| 11 | 80.0 | 0.273 | 29.4 | 2.77 |
| 11 | 80.0 | 0.299 | 21.9 | 2.36 |
| 12 | 72.0 | 0.213 | 50.3 | 3.03 |
| 12 | 72.0 | 0.233 | 41.5 | 2.94 |
| 12 | 72.0 | 0.245 | 35.4 | 2.90 |
| 12 | 72.0 | 0.273 | 24.3 | 2.62 |
| 13 | 62.0 | 0.213 | 44.2 | 2.75 |

†Developer concentrations in moles/liter.

Table II   (continued)

| Examples 10 through 16 | | | | |
|---|---|---|---|---|
| Photospeed and Contrast | | | | |
| Example | Percent Tri-DAQ Content | †Developer Concentration | Photospeed mJ/cm$^2$ | Contrast |
| 13 | 62.0 | 0.233 | 35.4 | 2.58 |
| 13 | 62.0 | 0.245 | 29.8 | 2.66 |
| 13 | 62.0 | 0.273 | 19.3 | 2.24 |
| 14 | 34.5 | 0.213 | 25.5 | 1.88 |
| 14 | 34.5 | 0.233 | 18.3 | 1.85 |
| 14 | 34.5 | 0.245 | 13.3 | 1.76 |
| 15 | 72.0 | 0.245 | 29.3 | 2.61 |
| 16 | 72.0 | 0.245 | 29.5 | 2.47 |

†Developer concentrations in moles/liter.

EXAMPLES 17 through 23 (Examples 17-22 are for comparison purposes, only Example 23 is an embodiment of the present invention)

Measurement of Slightly Exposed Film Thickness Remaining After Development

Film thickness remaining after slight exposure is detailed in Table VIII. In these experiments, the dose was varied between 0.5 an 2.0 mJ/cm$^2$. Initial average film thickness and final film thickness were measured on a Namometrics Nanospec. Exposure was followed by development in TMAH/water developers at the concentrations given in Table III. The film thickness remaining after partial exposure is excellent better than 97 percent for compositions of Examples 17 through 20, 22 and 23.

In a lithographic process, it is highly desirable to maximize unexposed and slightly exposed film thickness remaining after development. The resist compositions claimed in this invention have excellent performance in this respect. High film thickness remaining after development and high film thickness remaining after slight exposure are evidence that the dissolution rate in developer is essentially controlled by photoproducts of the PAC which have three or more indene-carboxylic acid groups bonded to the same ballast molecule, giving a characteristic threshold-energy type dissolution response to development.

These results can be compared to photoresist compositions given in Japanese Patent 60/121445 and European Patent Application No.85300184.0, which have the property of poor unexposed film thickness remaining after development, typically in the range of 87.0 to 93.5 percent. The slightly exposed film thickness remaining after development properties of the compositions given in Japanese Patent 60/121445 and European Patent Application No. 85300184.0 could be expected to be proportionally further diminished. The resist compositions of Japanese Patent 60/121445 and European Patent Application No. 85300184.0 contain photoactive compounds with two or more 1-oxo-2-diazonaphthalene-5-sulfonate residues bonded to the same ballast molecule. The property of decreased film thickness remaining after development in these compositions are evidence that the dissolution rate in developer is not essentially controlled by photoproducts of the PAC which have three or more indene-carboxylic acid groups bonded to the same ballast molecule. This diminished performance may be because these said compositions contained different resins and different solvents than those described in this present invention.

Table III

| Examples 17 through 23 | | | | | |
|---|---|---|---|---|---|
| Slightly Exposed Film Thickness Remaining After Development | | | | | |
| Example | Composition of Example | Percent Tri-DAQ Content | †Deveioper Concentration | Slight Dose ,mJ/cm$^2$ | *FTR, Slight Dose |
| 17 | 10 | 96.5 | 0.213 | 2.7 | 99.5 |
| 17 | 10 | 96.5 | 0.233 | 2.4 | 99.3 |
| 17 | 10 | 96.5 | 0.245 | 2.1 | 99.2 |

†Developer concentrations in moles/liter.

*"FTR" is percent film thickness remaining after development.

Table III   (continued)

| Examples 17 through 23 | | | | | |
|---|---|---|---|---|---|
| Slightly Exposed Film Thickness Remaining After Development | | | | | |
| Example | Composition of Example | Percent Tri-DAQ Content | †Deveioper Concentration | Slight Dose ,mJ/ $cm^2$ | *FTR, Slight Dose |
| 17 | 10 | 96.5 | 0.273 | 1.7 | 98.9 |
| 17 | 10 | 96.5 | 0.299 | 1.1 | 98.4 |
| 18 | 11 | 80.0 | 0.213 | 2.1 | 98.3 |
| 18 | 11 | 80.0 | 0.233 | 1.9 | 99.3 |
| 18 | 11 | 80.0 | 0.245 | 1.7 | 99.4 |
| 18 | 11 | 80.0 | 0.273 | 1.2 | 94.7 |
| 18 | 11 | 80.0 | 0.299 | 0.5 | 97.6 |
| 19 | 12 | 72.0 | 0.213 | 1.8 | 99.1 |
| 19 | 12 | 72.0 | 0.233 | 1.6 | 97.8 |
| 19 | 12 | 72.0 | 0.245 | 1.5 | 98.4 |
| 20 | 12 | 72.0 | 0.273 | 1.0 | 96.4 |
| 20 | 13 | 62.0 | 0.213 | 1.5 | 98.1 |
| 20 | 13 | 62.0 | 0.233 | 1.5 | 98.3 |
| 20 | 13 | 62.0 | 0.245 | 1.1 | 97.9 |
| 20 | 13 | 62.0 | 0.273 | 0.8 | 93.5 |
| 21 | 14 | 34.5 | 0.213 | 0.9 | 96.3 |
| 21 | 14 | 34.5 | 0.233 | 0.7 | 88.1 |
| 21 | 14 | 34.5 | 0.245 | 0.4 | 87.7 |
| 22 | 15 | 72.0 | 0.245 | 1.0 | 98.5 |
| 23 | 16 | 72.0 | 0.245 | 1.0 | 98.9 |

†Developer concentrations in moles/liter.

*"FTR" is percent film thickness remaining after development.

EXAMPLE 24

Measurement of Resist Resolution for Resists Containing Various Contents of Tri-DAQ PAC.

Resolution has an exact physical definition in terms of modulation of intensity between adjacent images (as described by P.S. Gwozdz, Proc. SPIE, Vol. 275 p. 156-164, 1981.) The most demanding and a proper method for measuring actual differences in resist resolution is to examine equal multiple equal line/space features printed on a phototool at a small enough feature size to degrade the aerial image of the light intensity (as explained by P.D. Flanner III, S. Subramanian and A.R. Neureuther, Proc. SPIE, Vol. 633, p. 239-244, 1986). For this purpose, we have used a Perkin-Elmer 341 scanning optical projector to print multiple equal 1.25 μm line/space patterns. Commercially available resists perform poorly under these conditions, giving very sloped sidewall angles and rounded tops of raised lines.

The resolution with resist compositions of Examples 10 through 16 were evaluated using 1.2 μm films which were track hot-plate soft-baked at 100°C for 45 seconds and exposed in the said manner described above. Developer concentrations were varied. The printed line/space patterns were examined using scanning electron microscopy. The resolution with resist compositions of Examples 10, 11, 12, 15 and 16 were excellent giving features with good sidewall angles and a flat top surface. The resolution with the composition of Example 13 was slightly worse than the aforementioned. The resolution with the composition of Example 14 was poor, with a poor sidewall angle and rounded tops. The resolution with the composition of Example 14 was similar to the commercially available Shipley 1470 photoresist using Shipley 312 developer at the recommended dilution. Other commercially available photoresist products yield a resolution similar to that obtained with Shipley Microposit® 1470.

Evaluations of the composition of Example 10, which contained PACs with tri-DAQ content of about 96.5 weight percent, exhibited residues adhering to the substrate surface. These residues persisted in all reasonable developer concentrations and developer processes. These residues, known as 'scum' by those familiar with the industry, would harm the production of microelectronic devices, and are highly undesirable. Evaluation of compositions of Examples 11 through 16 did not find any appreciable residue. Thus it appears, for photoresist compositions containing said resins, solvent and PAC's, that tri-DAQ contents of about 95-100 weight percent would be undesirable.

The resolution with compositions containing PACs with fit-DAQ contents between about 50 and 90 weight percent were quite good and superior to several commercially available products.

EXAMPLE 24A

Composition Containing Hexa-DAQ PAC

A composition consisting of 10.575g of the resin of Example 1 and 1.9259 of the PAC of Example 8 were dissolved into a solvent consisting of 5.063g of anisole, 5.063g of amyl acetate and 27.535g of ethyl lactate followed by filtration through a 0.2 μm Teflon filter. The photoresist was spin coated and track hot-plate baked to give 1.2 μm films, which were exposed to light in the manner described in Example 24. The resist was developed using 0.29 M TMAH/water developer at 22°C for 60 seconds. Scanning electron microscopic evaluation showed high resolution in reproducing multiple equal 1.25 μm line/space features with good sidewall angles and a flat top surface. Examples 25 and 26 demonstrate positive working photoresist compositions containing novel resins of this invention. These resist compositions were evaluated essentially as described in Example 10.

EXAMPLES 25 and 26

Positive Photoresists Based on Novel Resins

EXAMPLE 25

| Composition: | Resin of Example 2 | 21.83g |
|---|---|---|
| | PAC of Example 5 | 4.16g |
| | Ethyl lactate | 52.88g |
| | Anisole | 9.78g |
| | Amyl acetate | 9.78g |

| Performance: | Photosensitivity, mJ/cm$^2$ | 71.1 |
|---|---|---|
| | Contrast | 2.83 |
| | Initial film thickness | 1.132 |

EXAMPLE 26

| Composition: | Resin of Example 3 | 21.83g |
|---|---|---|
| | PAC of Example 5 | 4.16g |
| | Ethyl lactate | 52.88g |
| | Anisole | 9.78g |
| | Amyl acetate | 9.78g |

| Performance: | Photosensitivity, mJ/cm$^2$ | 21.0 |
|---|---|---|
| | Contrast | 1.57 |
| | Initial film thickness | 1.227 |

EXAMPLES 27 and 28

Positive Photoresists Based on Novel Acetylated PACs

EXAMPLE 27

The following example demonstrates a positive working photoresist composition consisting of an acylated PAC prepared according to Example 6, a novolac resin prepared according to Example 1, and a solvent mixture according to the present invention. Greater than 85 percent by weight of the PAC molecules were free of acidic hydrophilic groups.

| Composition: | |
|---|---|
| Novolac resin of Example 1: | 9.60g |
| Acylated PAC of Example 6: | 2.40g |
| Solvent: ethyl lactate, anisole, amyl acetate, in the ratio of 73:13.5:13.5: | 36.26g |

The photoresist composition was spin coated onto 100-mm diameter bare silicon wafers and baked on a hot plate for 45 seconds at 100°C to give films of 1.2 microns in thickness. Using these wafers, and a developer consisting of a 0.245 N TMAH in water, the photosensitivity and contrast of the photoresist was determined by the method described in Example 10 and found to be 50.3 mJ/cm$^2$ and 2.58, respectively.

EXAMPLE 28:

The following example demonstrates a positive working photoresist using fully acylated PAC free of molecules with acidic hydrophilic groups prepared according to Example 7, a resin binder prepared according to Example 2 and a solvent mixture according to the present invention.

| Composition: | |
|---|---|
| Resin of Example 2: | 6.02g |
| Acylated PAC of Example 7: | 1.52g |
| Solvent: ethyl lactate anisole, amyl acetate, in the ratio of 73:13.5:13.5: | 23.10g |

The photoresist composition was spin coated onto 100-mm diameter bare silicon wafers and baked on a hot plate for 45 seconds at 100°C to give films of 1.2 microns in thickness. Using these wafers, and a developer consisting of a 0.245 N water solution of TMAH, the photosensitivity and contrast of the photoresist was determined by the method described in Example 10 and found to be 54.3 mJ/cm$^2$ and 2.52. respectively.

EXAMPLE 29:

The following example demonstrates the superior solvency of an anisole-ethyl lactate-amyl acetate containing solvent mixture in dissolving an essentially fully esterified THBP PAC over an ethyl cellusolve acetate based solvent mixture commonly used to dissolve positive photoresist compositions.

| Resin of Example 1 | Solvent Mixture (parts/100) | Grams of PAC to Dissolve at 20°C |
|---|---|---|
| 2.5g | Anisole/Amyl acetate/Ethyl lactate (30/10/60) | 0.5 |
| 2.5g | Ethyl cellusolve acetate/n-Butyl acetate (90/10) | 0.2 |

EXAMPLE 30

In order to show the superiority of a solvent mixture according to this invention over the state of the art, the performance of the following resist compositions were compared with one another:

| A. | Resin of Example 1 | 21.00 g |
|---|---|---|
| | PAC of Example 5 | 5.25 g |

(continued)

| | | |
|---|---|---|
| | Ethyl lactate | 51.79 g |
| | Anisole | 9.58 g |
| | Amyl acetate | 9.58 g |
| B. | Resin of Example 1 | 14.04 g |
| | PAC of Example 5 | 3.51 g |
| | Ethyl cellosolve acetate | 42.70 g |
| | n-Butyl acetate | 4.74 g |
| C. | Resin of Example 1 | 18.21 g |
| | PAC of Example 5 | 4.55 g |
| | Propylene glycol monomethyl ether acetate | 55.34 g |
| | Anisole | 6.15 g |

| Results | | | |
|---|---|---|---|
| Resist Composilions | A | B | C |
| Film thickness at 4,000 rpm | 15,510 Å | 12,153 Å | 14.249 Å |
| Photospeed[1]. EE (mj/cm$^2$) | 53.2 | 62.7 | - |
| Photosensitivity[1] Eo (mj/cm$^2$) | 22.36 | 24.24 | - |
| Contrast[1] (gamma) | 2.5 | 2.11 | - |
| [1]Determined at a constant film thickness of 12.100 Å +/-150 Å. | | | |

These results show that resist composition A of the present invention requires lower percentage of solids to product a given film thickness of resist than the resist compositions B and C that are based on conventional solvents of prior art. The lower exposure dose required for resist compositions A allows higher water throughput per given time during the article manufacture and the higher contrast number of A is indicative of higher resolution capability.

EXAMPLE 31

The following example demonstrates the importance of an essentially pure ethyl lactate in resist compositions according to this invention. Two resist compositions were prepared essentially as described in Example 30 A. In one resist composition commercially available ethyl lactate (containing about 97 percent ethyl lactate, about 3 percent other impurities, as determined by standard gas chromatography method) was used. The other resist composition was prepared using a freshly distilled ethyl lactate that was determined by gas chromatography to be greater than about 99% pure. Both resist samples were filtered through a 0.2 um filter before stored in a refrigerated environment for about four months. The samples were then spin coated onto clean silicon wafers and examined under monochromatic light. The films spun from the resist sample containing the commercial ethyl lactate typically showed about 120 visible particles per wafer while the resist films spun from the purified ethyl lactate were of high quality with no particles present.

## Claims

1. A composition responsive to activating radiation to form a latent image developable with an aqueous alkali solution comprising at least one alkali soluble resin and at least one photoactive compound that is an ester or polyester derived from the reaction of an oxodiazonaphthalene sulfonyl or carboxylic acid halide with a hydroxy or polyhydroxy ballast compound dissolved in a solvent mixture comprising anisole, ethyl lactate and amyl acetate.

2. The composition of claim 1, wherein the solvent mixture contains ethyl lactate in at least 60 percents by weight based on the total weight of said solvent mixture.

3. The composition according to claim 1 or 2, wherein the ethyl lactate has a purity of greater than 99 percent.

4. The composition of any one of claims 1 to 3, further comprising one or more additives selected from the group consisting of colorants, dyes, anti-striation agents, plasticizers, speed-enhancers, contrast-enhancers, and surfactants.

5. Use of a photoresist composition as claimed in any one of the preceding claims 1 to 4 for coating a solid support.

6. The use of claim 5, wherein said solid support is selected from the group consisting of semiconductor materials, metals, planarizing, barrier or etch-resistant types of organic or inorganic layers, underlying films and coatings, other types of resist films, antireflective coatings, plastic films, wood, paper, ceramics, glass, laminates and textiles.

7. The use of claim 5 or 6, wherein said support is selected from the group consisting of a silicon-based or gallium arsenide-based wafer, aluminum and silicon dioxide.

8. Use of a photoresist composition as claimed in any one of claims 1 to 4 in the manufacture of integrated electronic circuits.

**Patentansprüche**

1. Auf aktivierende Strahlung unter Bildung eines mit einer wäßrigen Alkalilösung entwickelbaren latenten Bildes ansprechende Zusammensetzung, die wenigstens ein alkalilösliches Harz und wenigstens eine lichtempfindliche Verbindung umfaßt, wobei die lichtempfindliche Verbindung ein aus der Umsetzung eines Oxodiazonaphthalinsulfonyl- oder Oxodiazonaphthalincarbonsäurehalogenids mit einer Hydroxy- oder Polyhydroxyballastverbindung abgeleiteter Ester oder Polyester ist, der in einem Anisol, Ethyllactat und Amylacetat umfassenden Lösungsmittelgemisch gelöst ist.

2. Zusammensetzung nach Anspruch 1, **dadurch gekennzeichnet, daß** das Lösungsmittelgemisch, bezogen auf dessen Gesamtgewicht, wenigstens 60 Gew.- % Ethyllactat enthält.

3. Zusammensetzung nach Anspruch 1 oder 2, **dadurch gekennzeichnet, daß** das Ethyllactat eine Reinheit von mehr als 99 % aufweist.

4. Zusammensetzung nach einem der Ansprüche 1 bis 3, die ferner wenigstens einen aus der aus Pigmenten, Farbstoffen, Mitteln zur Verhinderung von Schlierenbildung, Weichmachern, empfindlichkeitssteigernden Mitteln, Kontrastverstärkern und oberflächenaktiven Mitteln bestehenden Gruppe ausgewählten Zusatz umfaßt.

5. Verwendung einer Photoresist-Zusammensetzung gemäß einem der vorhergehenden Ansprüche 1 bis 4 zur Beschichtung eines festen Trägers.

6. Verwendung nach Anspruch 5, **dadurch gekennzeichnet, daß** der feste Träger aus der aus Halbleitermaterialien, Metallen, organischen oder anorganischen Schichten vom Typ der Planarisierschichten, Sperrschichten oder ätzbeständigen Schichten, unterliegenden Filmen und Beschichtungen, anderen Arten von Resistfilmen, Antireflexionsbeschichtungen, Kunststoffilmen, Holz, Papier, Keramik, Glas, Laminaten und Textilstoffen bestehenden Gruppe ausgewählt ist.

7. Verwendung nach Anspruch 5 oder 6, **dadurch gekennzeichnet, daß** der Träger aus der aus einer Halbleiterscheibe auf Grundlage von Silicium oder Galliumarsenid, Aluminium und Siliciumdioxid bestehenden Gruppe ausgewählt ist.

8. Verwendung einer Photoresist-Zusammensetzung gemäß einem der Ansprüche 1 bis 4 bei der Herstellung von integrierten elektronischen Schaltkreisen.

**Revendications**

1. Composition sensible à un rayonnement d'activation pour former une image latente pouvant être développée avec une solution alcaline aqueuse comprenant au moins une résine soluble dans les alcalis et au moins un composé photoactif, qui est un ester ou un polyester qui est dérivé de la réaction d'un halogénure d'oxodiazonaphtalènesulfonyle ou d'acide carboxylique avec un composé ballast hydroxylé ou polyhydroxylé dissous dans un mélange de solvants comprenant de l'anisole, du lactate d'éthyle et d'acétate d'amyle.

2. Composition selon la revendication 1, dans laquelle le mélange de solvants contient du lactate d'éthyle en une quantité d'au moins 60 % en poids par rapport au poids total dudit mélange de solvants.

3. Composition selon la revendication 1 ou 2, dans laquelle le lactate d'éthyle a une pureté supérieure à 99 %.

4. Composition selon l'une quelconque des revendications 1 à 3, comprenant en outre un ou plusieurs additifs choisis parmi l'ensemble comprenant les colorants, les teintures, les agents anti-stries, les plastifiants, les agents augmentant la rapidité, les renforçateurs de contraste et les tensioactifs.

5. Utilisation d'une composition de photoréserve selon l'une quelconque des revendications précédentes 1 à 4, pour revêtement ou couchage sur support solide.

6. Utilisation selon la revendication 5, dans laquelle ledit support solide est choisi parmi l'ensemble comprenant les matériaux servi-conducteurs, les métaux, les couches organiques ou inorganiques de type à effet de planarisation, à effet isolant ou résistantes à la gravure, les films et revêtements sous-jacents, d'autres types de films de réserve, les revêtements anti-réfléchissants, les films plastiques, le bois, le papier, la céramique, le verre, les stratifiés et les textiles.

7. Utilisation selon la revendication 5 ou 6, dans laquelle ledit support est choisi parmi l'ensemble comprenant les microplaquettes à base de silicium ou d'arséniure de gallium, l'aluminium et le dioxyde de silicium.

8. Utilisation d'une composition de photoréserve selon l'une quelconque des revendications 1 à 4, pour fabriquer des circuits électroniques intégrés.